(19) Europäisches Patentamt
European Patent Office
Office européen des brevets

(11) **EP 3 968 431 A1**

(12) **DEMANDE DE BREVET EUROPEEN**

(43) Date de publication:
**16.03.2022 Bulletin 2022/11**

(21) Numéro de dépôt: **21196232.9**

(22) Date de dépôt: **13.09.2021**

(51) Classification Internationale des Brevets (IPC):
*H01M 10/0525* (2010.01)  *H01M 10/42* (2006.01)
*H01M 10/44* (2006.01)  *H01M 10/48* (2006.01)
*H01M 10/633* (2014.01)  *H02J 7/00* (2006.01)
*G01R 31/367* (2019.01)  *G01R 31/382* (2019.01)
*G01R 31/374* (2019.01)  *G01R 31/392* (2019.01)

(52) Classification Coopérative des Brevets (CPC):
**H01M 10/0525; G01R 31/374; G01R 31/382;
G01R 31/392; H01M 10/425; H01M 10/443;
H01M 10/486; H01M 10/633; H02J 7/007192;
H02J 7/007194;** H01M 2010/4271

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **15.09.2020 FR 2009305**

(71) Demandeur: **Commissariat à l'énergie atomique
et aux énergies alternatives
75015 Paris (FR)**

(72) Inventeur: **GUILLET, Nicolas
38054 GRENOBLE CEDEX 09 (FR)**

(74) Mandataire: **INNOV-GROUP
310, avenue Berthelot
69372 Lyon Cedex 08 (FR)**

(54) **PROCÉDÉ ET DISPOSITIF DE GESTION DU COMPORTEMENT THERMIQUE D'UNE BATTERIE**

(57) L'invention concerne un procédé de gestion du comportement thermique d'une batterie (BATT), ledit procédé consistant à :
- Employer un modèle thermique (MOD_TH) de la batterie, configuré pour estimer, à chaque instant, une puissance thermique ($W_{th}$) générée par la batterie en fonction d'une puissance électrique ($W_{elect}$) mesurée traversant la batterie, ledit modèle thermique comportant une loi à la charge et une loi à la décharge, chaque loi étant basée sur l'état de charge de la batterie (SoC) et sur sa température (T) et intégrant la constante de temps ($\tau$) de la batterie,
- Contrôler (CTRL) la puissance thermique ($W_{th}$) générée par la batterie.

Fig. 1

EP 3 968 431 A1

**Description**

**Domaine technique de l'invention**

La présente invention se rapporte à un procédé et à un dispositif de gestion du comportement thermique d'une batterie électrique.

**Etat de la technique**

Au cours de son fonctionnement, la température d'une batterie peut fortement varier, selon ses caractéristiques intrinsèques, l'environnement dans lequel elle évolue, la puissance électrique qui la traverse (en charge ou en décharge), ou selon l'équipement de régulation de la température qui lui est éventuellement associé (ventilation, refroidissement, chauffage...).

Il est bien connu que le fonctionnement à températures extrêmes (basses températures < 0°C ou hautes températures > 45°C) peut avoir des conséquences importantes sur la durée de vie de la plupart des types de batteries.

En outre, de nombreuses applications soumettent les batteries à de très fortes contraintes, comme par exemple :

- Une recharge la plus rapide possible,
- Beaucoup de cycles de charge/décharge,
- De fortes puissances à fournir ou à accepter.

Les conséquences sur les matériaux qui constituent la batterie peuvent être multiples mais l'une d'elles est généralement une variation substantielle de la température interne de la batterie. Si cette variation de température est très rapide, elle peut de surcroît être inhomogène au sein de la batterie et conduire à de fortes contraintes locales, à la fois thermiques et mécaniques, qui peuvent accélérer certains phénomènes de dégradation des matériaux et des performances de la batterie.

Il n'est par ailleurs pas aisé de déterminer précisément la température interne d'une batterie. La constante de temps entre l'émission de chaleur par les composants de la batterie et sa diffusion vers la surface externe de batterie peut ainsi être très importante, jusqu'à plusieurs minutes, même sur une batterie de taille réduite. En outre, la température de surface d'une batterie est souvent très loin d'être uniforme.

Des techniques d'analyse des propriétés thermiques des batteries ont été mises en œuvre pour évaluer leur état de santé avec des mesures de température ou de flux de chaleur échangé avec l'environnement.

Les techniques connues ne permettent pas de s'assurer qu'une batterie, en charge ou en décharge, ne subit pas des contraintes thermiques trop importantes. Les solutions actuelles qui permettent de surveiller la température de la batterie sont souvent inefficaces car les actions de régulation ou de mises en sécurité sont souvent mises en place trop tardivement, notamment du fait de la constante de temps de la batterie.

Des solutions de gestion du comportement thermique d'une batterie sont décrites dans les documents US2012/188086A1, US2019/148952A1 et CN108062086A.

Le but de l'invention est de proposer un procédé qui permet de surveiller efficacement le comportement thermique d'une batterie pour éventuellement mettre en place des actions de régulation/alerte qui sont adaptées à la situation thermique réelle de la batterie.

**Exposé de l'invention**

Ce but est atteint par un procédé de gestion du comportement thermique d'une batterie, qui consiste à :

- Déterminer une constante de temps de la batterie, ladite constante de temps correspondant à l'intervalle de temps existant entre le moment où de l'énergie thermique est dégagée par la batterie et le moment où un flux de chaleur correspondant est mesuré en surface de la batterie,
- Employer un modèle thermique de la batterie, configuré pour estimer, à chaque instant, une puissance thermique générée par la batterie en fonction d'une puissance électrique mesurée traversant la batterie, ledit modèle thermique comportant une loi à la charge et une loi à la décharge, chaque loi étant basée sur l'état de charge de la batterie et sur sa température et intégrant la constante de temps de la batterie,
- Contrôler la puissance thermique générée par la batterie.

Selon une particularité, le procédé comporte également des étapes de :

- Estimation de la puissance thermique générée à chaque instant par la batterie en fonction de la puissance électrique fournie à chaque instant par la batterie lors de sa charge ou générée à chaque instant par la batterie lors de sa décharge, ladite puissance thermique étant déterminée à partir dudit modèle thermique,

- Comparaison de la puissance thermique estimée à chaque instant ou d'une variation de la puissance thermique estimée au cours du temps à la charge ou à la décharge avec une valeur limite,
- Contrôle de la puissance électrique fournie à la batterie lors de la charge ou générée par la batterie lors de la décharge pour maintenir ladite puissance thermique estimée en dessous de ladite valeur limite.

Selon une autre particularité, le procédé comporte des étapes de :

- Détermination à chaque instant d'une valeur limite de puissance électrique admissible par la batterie à partir d'une valeur limite de puissance thermique admissible pré-mémorisée injectée dans ledit modèle thermique,
- Contrôle de la puissance électrique traversant la batterie à la charge ou à a décharge pour maintenir cette puissance électrique en dessous de ladite valeur limite.

Selon une autre particularité, la puissance thermique est estimée à chaque instant en tenant compte également de l'état de la santé (SoH) de la batterie.

Selon une autre particularité, le procédé comporte une étape préalable de détermination de la constante de temps de la batterie, ladite constante de temps correspondant à l'intervalle de temps existant entre le moment où de l'énergie thermique est dégagée par la batterie et le moment où un flux de chaleur correspondant est mesuré en surface de la batterie.

Selon une autre particularité, le procédé comporte des étapes préalables d'établissement dudit modèle thermique de la batterie.

Selon une autre particularité, le procédé comporte une étape de vérification du modèle thermique de la batterie, par comparaison de la puissance thermique mesurée à plusieurs instants à la charge ou à la décharge avec la puissance thermique estimée auxdits instants à partir du modèle thermique de la batterie, non corrigé de la constante de temps de la batterie.

L'invention concerne également un dispositif de gestion du comportement thermique d'une batterie, le dispositif comportant :

- Un module de détermination d'une constante de temps de la batterie, ladite constante de temps correspondant à l'intervalle de temps existant entre le moment où de l'énergie thermique est dégagée par la batterie et le moment où un flux de chaleur correspondant est mesuré en surface de la batterie,
- Un module d'exécution d'un modèle thermique de la batterie configuré pour estimer, à chaque instant, une puissance thermique générée par la batterie en fonction d'une puissance électrique mesurée traversant la batterie, ledit modèle thermique comportant une loi à la charge et une loi à la décharge, chaque loi étant basé sur l'état de charge de la batterie et sur sa température et intégrant la constante de temps de la batterie,
- Un module de contrôle de la puissance thermique générée par la batterie. Selon une réalisation particulière, le dispositif comporte :
- Un module d'estimation de la puissance thermique générée à chaque instant par la batterie en fonction de la puissance électrique fournie à chaque instant par la batterie lors de sa charge ou générée à chaque instant par la batterie lors de sa décharge, ladite puissance thermique étant déterminée à partir dudit modèle thermique,
- Un module de comparaison de la puissance thermique estimée à chaque instant ou d'une variation de la puissance thermique estimée au cours du temps à la charge ou à la décharge avec une valeur limite,
- Un module de contrôle de la puissance électrique fournie à la batterie lors de la charge ou générée par la batterie lors de la décharge pour maintenir ladite puissance thermique estimée en dessous de ladite valeur limite.

Selon une autre réalisation particulière, le dispositif comporte :

- Un module de détermination à chaque instant d'une valeur limite de puissance électrique admissible par la batterie à partir d'une valeur limite de puissance thermique admissible pré-mémorisée injectée dans ledit modèle thermique,
- Un module de contrôle de la puissance électrique traversant la batterie à la charge ou à la décharge pour maintenir cette puissance électrique en dessous de ladite valeur limite.

Selon une autre réalisation particulière, la puissance thermique est estimée à chaque instant en tenant compte également de l'état de la santé de la batterie.

Selon une autre réalisation particulière, le dispositif comporte un module de détermination de la constante de temps de la batterie, ladite constante de temps correspondant à l'intervalle de temps existant entre le moment où de l'énergie thermique est dégagée par la batterie et le moment où un flux de chaleur correspondant est mesuré en surface de la batterie.

Selon une autre réalisation particulière, le dispositif comporte un module d'établissement dudit modèle thermique de la batterie.

Selon une autre réalisation particulière, le dispositif comporte un module de vérification du modèle thermique de la batterie, configuré pour comparer la puissance thermique mesurée à plusieurs instants à la charge ou à la décharge avec la puissance thermique estimée auxdits instants à partir du modèle thermique de la batterie, non corrigé de la constante de temps de la batterie.

**Brève description des figures**

D'autres caractéristiques et avantages vont apparaître dans la description détaillée qui suit, faite en liaison avec les figures annexées listées ci-dessous :

- La figure 1 représente de manière schématique le dispositif de gestion du comportement thermique d'une batterie, conforme à l'invention ;
- La figure 2 illustre les différentes étapes du procédé de gestion du comportement thermique d'une batterie, conforme à l'invention ;
- La figure 3 montre deux diagrammes illustrant l'influence des caractéristiques des batteries sur leur comportement thermique ;
- La figure 4 montre deux diagrammes illustrant l'influence du régime de fonctionnement de la batterie sur son comportement thermique ;
- La figure 5 montre deux diagrammes illustrant l'influence de la température ambiante sur le comportement thermique de la batterie ;
- La figure 6 montre deux diagrammes illustrant l'influence de la constante de temps sur le comportement thermique de la batterie ;
- La figure 7 montre deux diagrammes illustrant l'influence de l'état de santé de la batterie sur le comportement thermique de la batterie ;
- La figure 8 représente l'évolution du logarithme du flux de chaleur d'une batterie en fonction du temps ;
- La figure 9 illustre la différence entre le flux de chaleur mesuré sur une batterie de format 18650 et le flux de chaleur corrigé à partir de la constante de temps du système ;

**Description détaillée d'au moins un mode de réalisation**

L'invention s'applique à la gestion thermique d'une batterie BATT, par exemple une batterie de type métal-ion, avantageusement une batterie de type lithium-ion. Il peut par exemple s'agir d'une batterie de format cylindrique de type 18650 ou 21700.

Dans la présente demande, une batterie BATT peut être constituée d'une ou plusieurs cellules électrochimiques.

L'invention proposée vise à limiter l'apparition de gradients de température dans une batterie au cours de son fonctionnement, et ainsi à ralentir la dégradation des matériaux qui constituent la batterie pour maintenir ses performances le plus longtemps possible.

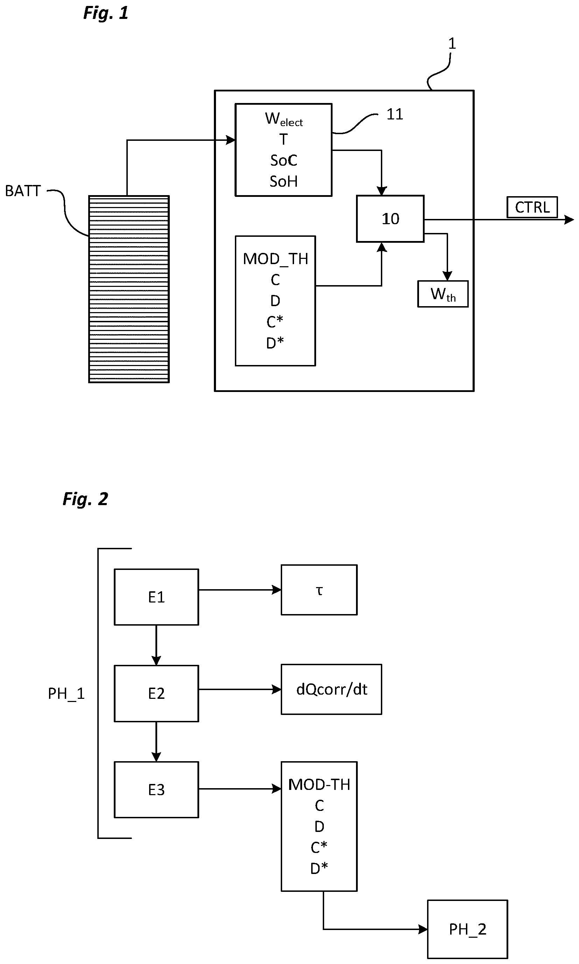

L'invention présentée en figure 1 consiste en un procédé de gestion du comportement thermique de la batterie électrique et en un dispositif 1 de gestion, configuré pour mettre en œuvre ce procédé.

Le dispositif 1 de gestion du comportement thermique de la batterie, comporte principalement des moyens 11 de mesure et de détermination de divers paramètres de la batterie et des moyens de traitement et de commande 10 configurés pour traiter lesdits paramètres. Le dispositif de gestion peut être intégré dans un équipement de type BMS (pour "Battery Management System").

Le procédé permet d'estimer à chaque instant la puissance thermique $W_{th}$ échangée par la batterie BATT avec son environnement, quel que soit son régime de fonctionnement, en charge ou en décharge.

La puissance thermique $W_{th}$ ainsi estimée peut être utilisée par le dispositif 1 de gestion pour :

- Limiter l'augmentation de température globale de la batterie en agissant par exemple sur un équipement de régulation thermique : ventilation, refroidissement, chauffage...
- Réduire l'apparition de gradients de température dans la batterie en limitant temporairement la puissance électrique autorisée sur la batterie (en charge ou en décharge).
- Détecter d'éventuels dysfonctionnements de la batterie et avertir, si nécessaire, l'utilisateur ou un système de surveillance qui garantit la sécurité de la batterie.

Différents phénomènes et paramètres influencent le comportement thermique de la batterie, notamment :

- Les caractéristiques intrinsèques de la batterie BATT (composition et structure interne, format etc...) ;
- Son régime de fonctionnement, charge ou décharge, et le type de fonctionnement en charge ou décharge ;
- L'environnement thermique de la batterie BATT, c'est-à-dire la température ambiante ;
- La constante de temps de la batterie ;
- L'état de santé de la batterie (appelé également SoH pour "State of Health") ;

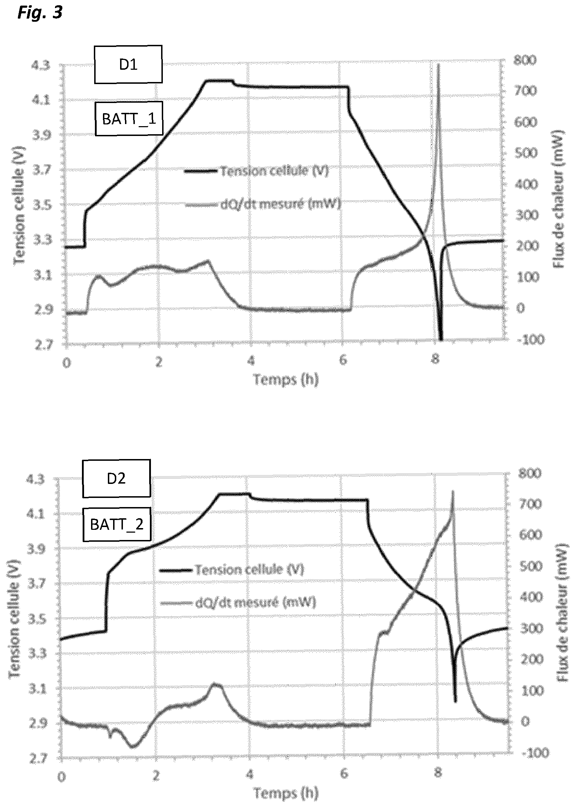

Ces phénomènes et paramètres sont détaillés ci-dessous, en liaison avec les figures 3 à 7.

**Les caractéristiques intrinsèques de la batterie**

Pour illustrer ce phénomène, on part de deux batteries BATT_1 et BATT_2, de type Li-ion de références différentes mais de formats identiques (cylindrique 18650) et ayant des performances similaires.

La figure 3 montre des exemples de flux de chaleur mesurés au cours d'un cycle de charge/décharge (CC-CV) à un régime de charge de C/3 et décharge à C/2 à 25°C. Les deux batteries Li-ion sont de références différentes mais de formats identiques (cylindrique 18650) et présentent des performances similaires. On a ainsi la référence BATT_1 sur le diagramme D1 et la référence BATT_2 sur le diagramme D2.

Sur la figure 3, nous pouvons ainsi constater que lors de la charge de la batterie BATT_1, le flux de chaleur mesuré n'est pas constant. Il augmente fortement en début de charge puis passe par une succession de minimum et maximum avant d'atteindre une valeur maximale à la fin de la charge à courant constant. Lors de la phase à tension constante, le courant diminue avec le temps et la chaleur générée par effet Joule en fait de même. A la décharge, la chaleur dégagée augmente rapidement au début de la décharge et s'accroît en permanence pour atteindre une valeur très élevée (800 mW d'énergie thermique échangée avec l'extérieur pour environ 4 W de puissance électrique fournie).

Pour la batterie BATT_2, nous pouvons observer un comportement très différent. Au début de la charge, le flux de chaleur mesuré est négatif. Cela signifie qu'une réaction chimique endothermique absorbe plus d'énergie thermique que l'effet Joule n'en produit. Cette tendance s'inverse dans la seconde partie de la charge avec une valeur maximale de chaleur échangée à la fin de la phase de charge à courant constant. Au cours de la décharge, cette batterie génère tout au long de la décharge beaucoup plus que chaleur que la batterie BATT_1, même si la puissance thermique est atteinte en fin de décharge.

Pour chaque référence de batterie, une signature thermique spécifique doit donc être prise en compte. Cette signature thermique dépend des réactions chimiques qui se produisent au sein de la batterie (chaleur réversible), de la structure interne de la batterie et en particulier de la résistance électrique.

**Régime de fonctionnement de la batterie**

Le régime de charge et de décharge de la batterie, et plus particulièrement la puissance électrique qui traverse la batterie, a une influence notable sur la quantité de chaleur échangée par la batterie avec son environnement. Plus la puissance électrique est élevée, plus la quantité de chaleur dégagée par effet Joule est importante.

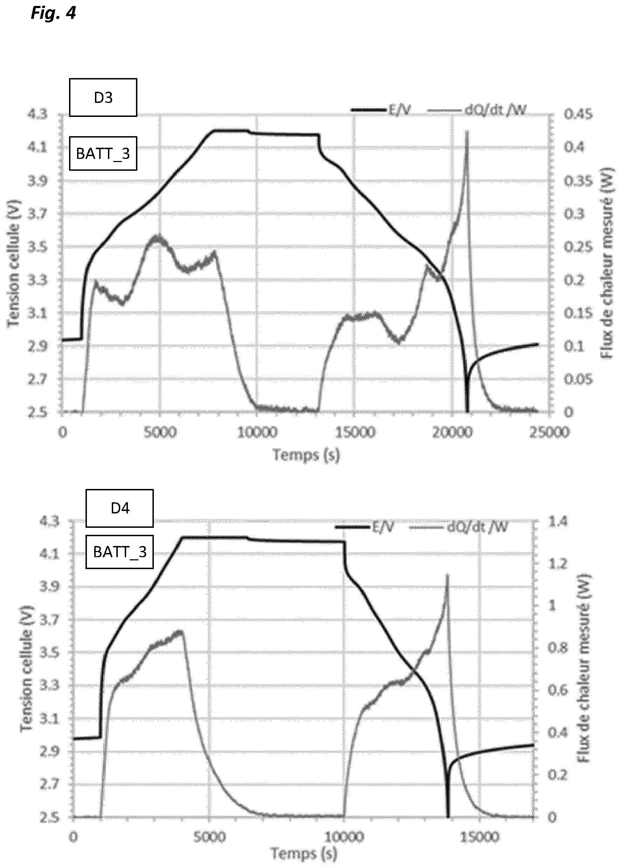

La figure 4 montre des exemples de comportement d'une cellule Li-ion de référence BATT_3 au cours de cycles de charge/décharge (CC-CV) à différents régimes de charge et de décharge. Sur le diagramme D3, les courbes d'évolution de la tension de cellule et les mesures de flux de chaleur au cours du cycle de charge/décharge à un régime de C/2. Sur le diagramme D4, nous avons la même chose à un régime de 1C.

Les deux courbes de la figure 4 présentent l'évolution de la tension d'une cellule d'une batterie et le flux de chaleur échangé par la batterie avec l'environnement en fonction du temps.

Pour rappel : la lettre C est utilisée pour définir le régime de charge/décharge d'une batterie et est égal à la capacité d'une batterie divisé par 1 heure. Pour une batterie 1600 mAh, la valeur C est de 1.6 A. Pour la même batterie, C/5 correspond à 320 mA et C/10 à 160 mA. C est donc relatif à la capacité de la batterie : le régime C de charge ou de décharge pour des batteries de différentes capacités est donc différent.

A partir des diagrammes D3 et D4, on constate ainsi que les signatures thermiques de cette même cellule de batterie Li-ion apparaissent comme très différentes, selon le régime de charge/décharge mis en place.

**Température ambiante**

La température de l'environnement peut également avoir une influence notable sur la quantité d'énergie thermique échangée par la batterie avec l'environnement au cours du fonctionnement. Lorsque la température augmente, la résistance électrique de l'électrolyte liquide diminue et la part des pertes sous forme de chaleur irréversibles (effet Joule) se réduit. La signature thermique de la batterie est dépendante de la température de l'environnement.

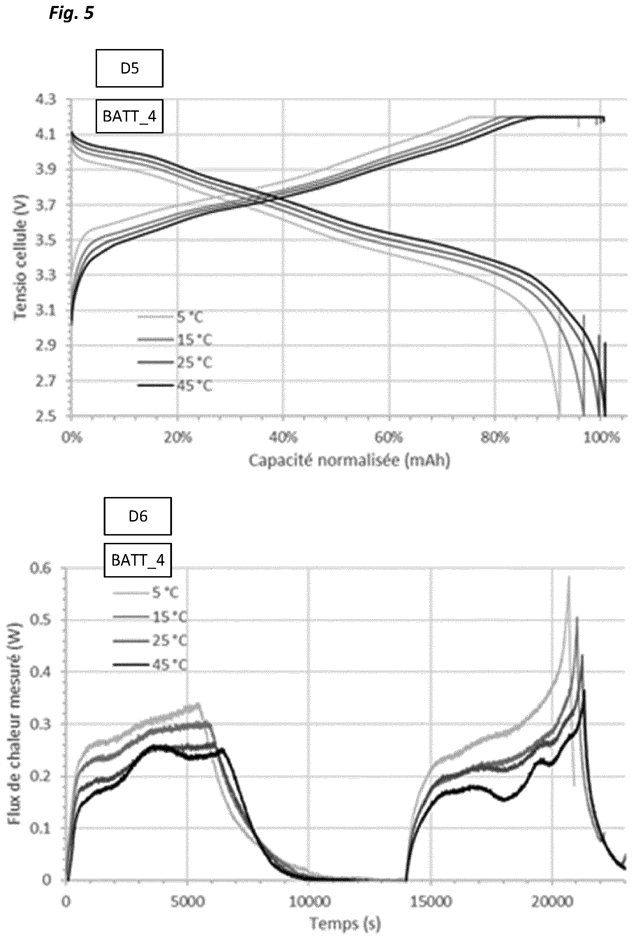

La figure 5 montre des exemples de comportement d'une cellule Li-ion de référence BATT_4 au cours de cycles de charge/décharge (CC-CV) à un régime de charge de C/2 et décharge à C/2 à différentes températures. Sur le diagramme D5, on visualise les courbes d'évolution de la tension de cellule en fonction de la capacité normalisée à 25 °C. Sur le diagramme D6, on visualise les flux de chaleur mesurés au cours du temps pendant les cycles charge - décharges aux différentes températures.

**Constante de temps de la batterie**

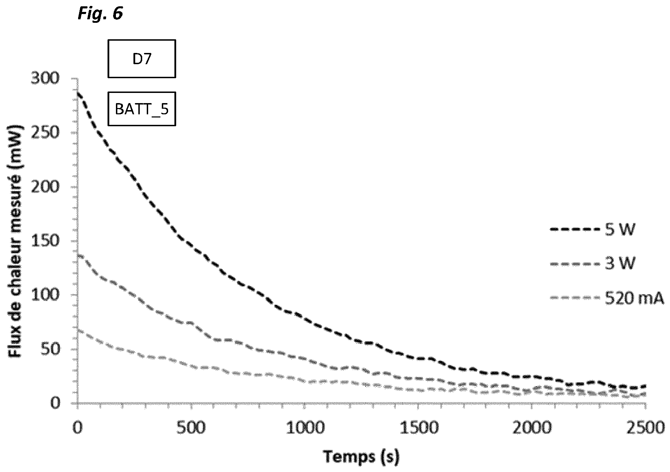

Il existe un certain retard entre l'instant où la chaleur est générée au sein des matériaux de la batterie et celui où le flux de chaleur est mesuré en surface de la batterie. Un exemple est donné sur la figure 6, présentant l'évolution du flux de chaleur mesuré sur une batterie après une décharge à courant constant ou puissance constante. Lorsque l'on arrête de décharger la batterie, c'est-à-dire qu'il n'y a plus de chaleur générée, le flux de chaleur mesuré diminue lentement avec le temps.

La figure 6 montre l'évolution du flux de chaleur dégagé par une cellule de batterie après une décharge à un courant constant (520 mA) ou à puissance constante (3 et 5 W).

Sur la figure 6, la constante de temps calculée dans les conditions de cet essai pour une cellule de batterie BATT_5 de format 18650 (format cylindrique de 18 mm de diamètre et 65 mm de longueur) est de l'ordre de 830 s, quelle que soit la puissance électrique de la décharge. Cet intervalle de temps peut fortement varier suivant la capacité calorifique de la batterie, sa masse, sa forme ainsi que les dispositifs mis en place pour favoriser les échanges de chaleur avec l'environnement et l'équipement de régulation de la température qui peut être employé.

**Etat de santé de la batterie**

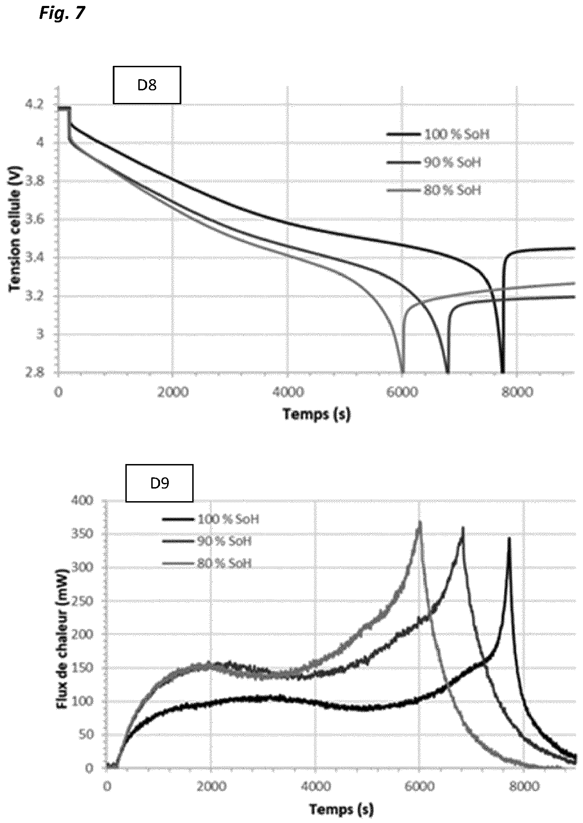

Au cours du vieillissement d'une batterie, le flux de chaleur dégagé au cours de la décharge peut fortement évoluer en raison de la possible augmentation de résistance interne (augmentation des pertes irréversibles par effet Joule) de la batterie, en raison de la perte de capacité ou de l'évolution des paramètres thermodynamiques des réactions électrochimiques (en particulier des termes enthalpiques et entropiques). L'influence du vieillissement des cellules de batteries sur les échanges thermiques avec l'environnement peut être illustrée par la figure 7.

Sur la figure 7, le diagramme D8 montre une comparaison de courbes de décharge à un courant correspondant à un régime de C/2 de cellules identiques à trois états de santé différents (100 %, 90 %, 80 %). Le diagramme D9 montre une comparaison de courbes de flux de chaleur dissipé pour ces mêmes cellules à trois états de santé différents.

On comprend de ce qui précède que pour chaque référence de batterie, une signature thermique particulière doit donc être considérée par le dispositif de gestion thermique. L'évolution de la chaleur dégagée dépend de l'état de charge de la batterie et du courant électrique qui la traverse, de la capacité calorifique de la batterie et de la qualité des échanges thermiques avec son environnement.

L'objet de cette invention est de proposer un procédé permettant à chaque instant de calculer une estimation de la puissance thermique (référencée $W_{th}$) qui sera générée au sein des matériaux qui constituent la batterie BATT en fonction de la puissance électrique qui pourrait traverser la batterie ($W_{elect}$ en charge ou en décharge) à partir des caractéristiques de la batterie et de son environnement (matériaux qui la constituent, température ambiante, état de santé, constante de temps...).

A partir de l'estimation de la puissance thermique $W_{th}$ en fonction de la puissance électrique $W_{elect}$, il est notamment possible d'établir un contrôle CTRL (voir figure 1) particulier pour adapter la stratégie d'utilisation de la batterie.

En référence à la figure 2, le procédé de gestion du comportement thermique de la batterie se découpe en deux phases principales, une première phase PH_1 dite d'apprentissage ou de calibration, permettant de générer un modèle thermique MOD_TH du système global intégrant la batterie et une deuxième phase, dite de surveillance, pendant laquelle le modèle thermique MOD_TH qui a été généré est employé pour surveiller le comportement thermique de la batterie BATT.

La phase de calibration PH_1 comporte plusieurs étapes. Ces étapes de calibration sont réalisées sur le système global, c'est-à-dire incluant la batterie dans son environnement, incluant éventuellement son équipement de régulation de température (ventilation, refroidisseur, chauffage...). La calibration peut être réalisé sur un seul système et les lois qui en résultent peuvent être appliquées à tous les systèmes identiques.

**Etape E1** : Détermination de la constante de temps $\tau$ de la batterie dans son environnement de fonctionnement. La constante de temps $\tau$ correspond à un intervalle de temps qui peut fortement varier suivant la capacité calorifique de la batterie, sa forme ainsi que suivant les dispositifs mis en place pour favoriser les échanges de chaleur avec l'environnement et l'équipement de régulation de la température associé.

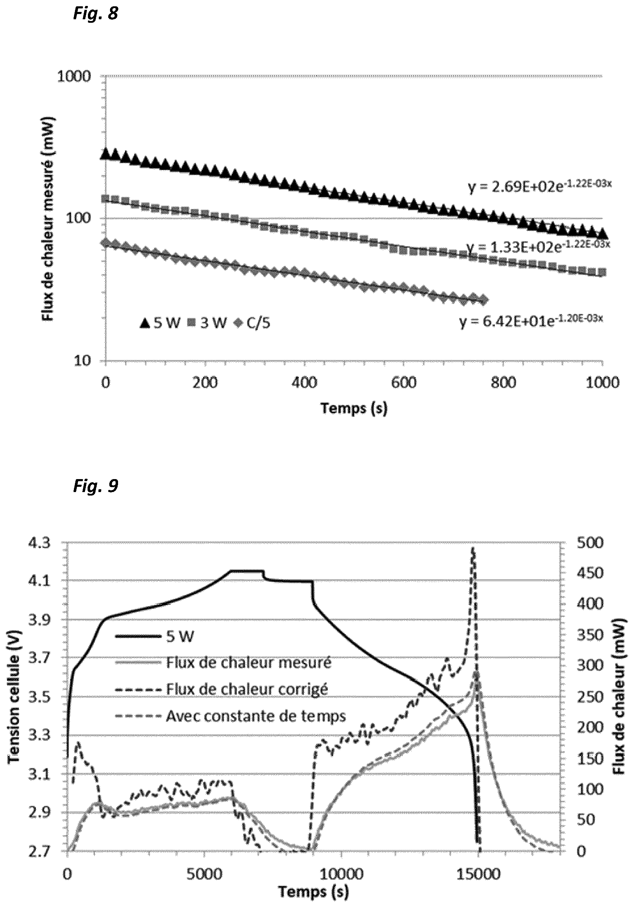

Pour calculer cette constante de temps, le dispositif de gestion mesure le flux de chaleur généré par la batterie BATT. La figure 8 représente ainsi l'évolution du logarithme du flux de chaleur en fonction du temps. En considérant que l'évolution du flux de chaleur mesuré $\dfrac{dQmes}{dt}$ diminue de manière exponentielle, nous pouvons calculer une constante de temps τ à partir de l'équation suivante :

$$\frac{dQmes}{dt} = A \, exp\left(\frac{-t}{\tau}\right)$$

avec :

- A un paramètre pré exponentiel qui évolue de manière proportionnelle à la puissance électrique qui traverse la batterie (dans ce cas, A = 74 x $W_{elec}$-100) ;
- t correspond au temps ;

Dans le cas de la figure 8, la constante de temps calculée pour les trois puissances électriques est de 825 s +/- 7 s.

Il est possible de réaliser ces mesures à différentes températures sur l'ensemble de la plage d'utilisation de la batterie et obtenir des lois d'évolution A(T) et τ (T) qui seront utilisées pour la gestion de la batterie.

**Etape E2** : Il s'agit d'une étape pendant laquelle des flux de chaleur émis par le système incluant la batterie sont mesurés à plusieurs instants successifs, dans plusieurs conditions de fonctionnement distinctes (état de charge de la batterie, température, puissance électrique, état de santé de la batterie éventuellement). Cette étape consiste à établir une relation qui permet de remonter au flux de chaleur généré à partir d'une mesure de flux de chaleur, de température de peau ou d'un autre paramètre relatif à la température apparente de la batterie (température d'un fluide caloporteur, vitesse d'un ventilateur asservi à la température...).

Pour cela, il est nécessaire de résoudre l'équation différentielle (équation de Tian et Calvet ci-dessous) pour déterminer la valeur des paramètres α et β qui permettent d'obtenir un flux de chaleur corrigé (en pointillés noirs sur la figure 9), à partir de la mesure de flux de chaleur (par exemple, ou autre indicateur de température) et de la constante de temps qui a été calculée à l'étape E1 (la constante de temps du système est considérée comme dépendante du système lui-même et n'évolue pas au cours du temps).

La loi de Tian et Calvet reprise ci-dessous exprime donc la correction des flux de chaleur mesurés à partir d'une loi d'évolution du flux de chaleur en fonction du temps :

$$dQcorr/dt = α(d(dQmes/dt))/dt) + β(dQmes/dt)$$

Avec :

- dQcorr/dt, le flux de chaleur corrigé de la constante de temps du système, et qui est censé refléter la puissance thermique générée à chaque instant par la batterie ;

- Le paramètre α qui est proportionnel à la capacité calorifique du système et correspond à la quantité de chaleur à fournir pour observer une variation du flux de chaleur ;

- Le paramètre β qui est relatif à la fuite de chaleur vers l'environnement par conductivité thermique ;

La figure 9 montre un exemple de comparaison entre le flux de chaleur mesuré sur une cellule de format 18650 et le flux de chaleur corrigé à partir de la constante de temps du système.

A partir de ces deux paramètres α, β qui sont propres au système étudié et qui peuvent être définis pour un lot complet de batteries de références identiques assemblées de manière identique, il est ainsi possible de calculer le flux de chaleur corrigé à chaque instant. La correction de la constante de temps du flux de chaleur est indispensable pour estimer la puissance thermique dégagée à chaque instant. Elle devient d'autant plus intéressante si la batterie est sollicitée par un profil de puissance électrique présentant des variations importantes.

**Etape E3** : Etablissement du modèle thermique de la batterie

A partir des données recueillies lors des étapes précédentes, il est possible d'établir un modèle thermique de la batterie, qui va permettre d'estimer à chaque instant la puissance thermique qui sera générée pour des valeurs étendues de puissance électrique de charge et de décharge de la batterie.

Le modèle thermique MOD_TH prend en compte l'ensemble des paramètres de fonctionnement de la batterie (charge/décharge, T, SoC, SoH) sur leur plage de variation, permettant ainsi d'estimer la puissance thermique en sortie générée par le système en fonctionnement.

Autrement dit, lors de l'étape E2 ci-dessus, il est possible de mesurer des flux de chaleur générés par le système, dans différentes conditions de fonctionnement. La loi d'évolution du flux de chaleur de Tian et Calvet permet de calculer une estimation des flux de chaleur générés à chaque instant dans chacune des conditions de fonctionnement considérées.

L'étape suivante consiste donc à développer un modèle qui permet d'établir une relation entre les flux de chaleurs générés (puissance thermique $W_{th}$) et la puissance électrique qui traverse la batterie ($W_{elect}$) pour l'ensemble des paramètres de fonctionnement notamment son état de charge SoC estimé (par le dispositif de gestion), sa température T (mesurée) et éventuellement son état de santé SoH.

On obtient ainsi deux lois qui régissent le fonctionnement du système dans lequel est employé la batterie :

Pour la charge : $W_{th} = W_{elect}$ x C(SoC, T)

Pour la décharge : $W_{th} = W_{elect}$ x D(SoC, T)

Avec :

- Wth la puissance thermique estimée pour la puissance électrique Welect à partir d'une loi C correspondant à l'évolution du rapport Wth/Welect pendant la charge de la batterie, et qui dépend de l'état de charge (SoC) et de la température (T) ; D est la loi équivalente à C, établie pour la décharge de la batterie.

Ces lois peuvent également être complexifiées en intégrant avantageusement l'évolution de l'état de santé (SoH) de la batterie au cours du temps :

Pour la charge : Wth = Welect x C(SoC, T, SoH)

Pour la décharge : Wth = Welect x D(SoC, T, SoH).

Cette phase de calibration peut être mise en œuvre pour obtenir les lois C et D qui permettent d'estimer la puissance thermique dégagée au sein des matériaux de la batterie en fonction de la puissance électrique qui pourrait la traverser (en charge, comme en décharge). Il est alors possible d'anticiper des variations brutales de quantité de chaleur dégagée lors du fonctionnement de la batterie.

Les lois C et D établis peuvent alimenter une base de données et pourront être utilisées sur un lot de batteries identiques ou similaires. Il est également possible de procéder à une calibration occasionnelle ou périodique pour vérifier que les lois C et D préalablement définies sont encore valables.

Il faut en effet noter que, à partir des lois C et D, nous pouvons prendre en compte la constante de temps du système et définir les lois C* et D* qui permettent d'estimer à tout instant le flux de chaleur (ou le paramètre thermique considéré : température de peau, du fluide caloporteur, vitesse de ventilateur etc...) et de comparer avec la valeur mesurée sur le système. Sur la figure 9, les valeurs calculées à partir des lois C* et D* sont représentées par la courbe en pointillés gris. Elles sont à comparer avec les valeurs mesurées (courbe en trait plein gris). Une dérive importante des lois serait le signe du vieillissement de la batterie ou d'un dysfonctionnement au sein de la batterie.

La mise en œuvre de la phase de calibration PH_1 nécessite de mesurer le flux de chaleur échangé par la batterie avec son environnement pour corréler celui-ci à la puissance électrique qui la traverse. Pour cela, on peut utiliser un ou plusieurs capteurs de flux de chaleur à la surface de la batterie, disposés préférentiellement sur les plus grandes surfaces d'échange de la batterie avec son environnement (faces latérales sur une batterie prismatique, sur la hauteur pour les formats cylindriques). Il est possible de disposer de sondes de température ou autre dispositif de mesure de température à la surface des batteries. Le principe est de pouvoir mesurer ou calculer la puissance thermique échangée par la batterie dans différentes conditions de fonctionnement (température, régime de fonctionnement).

La deuxième phase PH_2 du procédé de l'invention est une phase dite de surveillance du comportement thermique de la batterie. Elle consiste à utiliser le modèle thermique MOD_TH généré lors de la phase de calibration pour établir un contrôle CTRL particulier et surveiller le comportement thermique de la batterie BATT.

A partir du modèle thermique MOD_TH et des lois correspondantes, le dispositif de gestion peut ainsi calculer à chaque instant la puissance thermique équivalente à la puissance électrique $W_{elect}$ en charge ou décharge de la batterie.

Le traitement de la puissance thermique $W_{th}$ déterminée et le contrôle CTRL réalisé peuvent être multiples.

Le dispositif 1 de gestion de la batterie peut mettre à jour à chaque instant des valeurs limites de fonctionnement de la batterie, en puissance électrique, à la charge et à la décharge. La valeur limite de puissance thermique $W_{th\_max}$ admissible d'une batterie, à la charge ou à la décharge, ne change pas. Elle peut être fixée par le fabricant ou par l"utilisateur. En revanche, selon l'état de la batterie et ses conditions de fonctionnement, la puissance électrique qui traverse la batterie, pour laquelle la valeur limite de puissance thermique est atteinte, va évoluer au cours du temps. Le dispositif peut ainsi calculer à chaque instant une plage de puissance électrique admissible en charge et décharge [$W_{elect\_max\_d}$ - $W_{elect\_max\_c}$]. Les bornes ($W_{elect\_max\_d}$ et $W_{elect\_max\_c}$) peuvent être définies à partir de :

- La puissance thermique maximale choisie par le fabricant ou l'utilisateur : $W_{th\_max}$ ;

- La variation de puissance thermique admissible par unité de temps, choisie par le fabricant ou l'utilisateur : $dW_{th}/dt\_max$ ;

Le dispositif doit alors s'assurer que la puissance électrique qui traverse la batterie reste dans les limites calculées, ce qui permet de garantir la sécurité de fonctionnement de la batterie.

En variante, le dispositif 1 de gestion peut convertir à chaque instant la puissance électrique $W_{elect}$ qui traverse la batterie BATT en une puissance thermique $W_{th}$, en utilisant le modèle thermique MOD_TH de la batterie BATT, et comparer la puissance thermique $W_{th}$ ainsi calculée avec la valeur limite $W_{th\_max}$ admissible (fixée par le fabricant ou par l'utilisateur) ou sa variation admissible $dW_{th}/dt\_max$.

Selon une particularité de l'invention, le dispositif 1 de gestion peut être à même de vérifier que le modèle thermique MOD_TH de la batterie BATT reste valable au cours du temps et que les lois établies au départ permettent d'estimer la puissance thermique $W_{th}$ générée par les matériaux de la batterie au cours du fonctionnement, avec une erreur acceptable.

Pour vérifier les lois du modèle thermique MOD_TH, le dispositif 1 doit considérer les lois définies précédemment, non corrigées de la constante de temps $\tau$ de la batterie. Le dispositif 1 s'appuie alors sur les lois référencées C*(SoC, T, SoH) et D*(SoC, T, SoH) pour vérifier la bonne cohérence entre la puissance thermique qui est mesurée et celle qui a été estimée. Le dispositif compare les valeurs de puissance thermique échangées (ou les grandeurs connexes : température locale, température du circuit de refroidissement etc...) et mesurées à celles qui sont estimées par les lois du modèle, non corrigées de la constante de temps.

Il est possible d'utiliser une ou plusieurs informations relatives à la chaleur échangée par la batterie BATT avec son environnement de température de batterie. Ce peut être les informations provenant de capteurs de flux thermiques placés à la surface de la batterie, des sondes de température ou autres dispositifs de mesure de température locale, une information secondaire liée à l'équipement de régulation thermique telle que la vitesse d'un ventilateur, la température du liquide de refroidissement etc...

Partant de la vérification du modèle thermique MOD_TH, le dispositif 1 de gestion peut ainsi suivre l'état de santé SoH de la batterie. Dans un premier temps, l'évolution devrait être faible voire quasi nulle. Si l'évolution s'accélère, ce sera un signe de l'accélération des phénomènes de dégradation des matériaux.

Le dispositif 1 de gestion peut également vérifier si le vieillissement de la batterie BBATT est conforme à ce qui était attendu par le modèle MOD_TH défini. La détection d'un écart peut être attribuée à un dysfonctionnement inattendu. Dans ce cas, il est possible d'en informer l'utilisateur pour envisager une vérification ou programmer une maintenance.

De manière non limitative, la validité des lois lors de la vérification du modèle thermique MOD TH peut être évaluée à l'aide d'outils statistiques classiques. A titre d'exemple, il est possible d'utiliser l'écart type $\sigma$ des différences entre les valeurs mesurées et calculées sur les N-1 dernières mesures (N > 1). Si la différence calculée pour la mesure N est comprise dans une fourchette de valeurs de $2\sigma$ (contient statistiquement plus de 95 % des valeurs de différences calculées sur les N-1 dernières mesures), le système est jugé comme fonctionnant normalement. En revanche, si la différence calculée pour la mesure N est en dehors d'une fourchette de valeurs de $4\sigma$ (contient statistiquement plus de 99,99 % des valeurs de différences calculées sur les N-1 dernières mesures), nous pouvons considérer qu'entre la mesure N-1 et la mesure N, le système a subi une évolution notable et qu'il n'est plus convenablement représenté par le modèle de lois proposé.

L'invention présente ainsi de nombreux avantages, parmi lesquels :

- Une gestion thermique en temps réel des batteries, tenant compte notamment de sa constante de temps ;

- Une solution permettant de sécuriser l'emploi des batteries ;

- Une solution adaptable dans le temps, par une vérification régulière des lois qui régissent le comportement thermique de la batterie ;

**Revendications**

1.  Procédé de gestion du comportement thermique d'une batterie (BATT), **caractérisé en ce qu'**il consiste à :

- Déterminer une constante de temps ($\tau$) de la batterie, ladite constante de temps correspondant à l'intervalle de temps existant entre le moment où de l'énergie thermique est dégagée par la batterie et le moment où un flux de chaleur correspondant est mesuré en surface de la batterie,
- Employer un modèle thermique (MOD_TH) de la batterie, configuré pour estimer, à chaque instant, une puissance thermique ($W_{th}$) générée par la batterie en fonction d'une puissance électrique ($W_{elect}$) mesurée traversant la batterie, ledit modèle thermique comportant une loi à la charge et une loi à la décharge, chaque loi étant basée sur l'état de charge de la batterie (SoC) et sur sa température (T) et intégrant la constante de temps ($\tau$) de la batterie,
- Contrôler (CTRL) la puissance thermique ($W_{th}$) générée par la batterie.

2. Procédé selon la revendication 1, **caractérisé en ce qu'**il comporte des étapes de :

- Estimation de la puissance thermique ($W_{th}$) générée à chaque instant par la batterie en fonction de la puissance électrique ($W_{elect}$) fournie à chaque instant par la batterie (BATT) lors de sa charge ou générée à chaque instant par la batterie lors de sa décharge, ladite puissance thermique ($W_{th}$) étant déterminée à partir dudit modèle thermique (MOD_TH),
- Comparaison de la puissance thermique ($W_{th}$) estimée à chaque instant ou d'une variation de la puissance thermique estimée au cours du temps à la charge ou à la décharge avec une valeur limite,
- Contrôle de la puissance électrique ($W_{elect}$) fournie à la batterie lors de la charge ou générée par la batterie lors de la décharge pour maintenir ladite puissance thermique estimée en dessous de ladite valeur limite.

3. Procédé selon la revendication 1, **caractérisé en ce qu'**il comporte des étapes de :

- Détermination à chaque instant d'une valeur limite ($W_{elect\_max\_d}$, $W_{elect\_max\_c}$) de puissance électrique admissible par la batterie (BATT) à partir d'une valeur limite de puissance thermique ($W_{th\_max}$) admissible pré-mémorisée injectée dans ledit modèle thermique (MOD_TH),
- Contrôle de la puissance électrique ($W_{elect}$) traversant la batterie (BATT) à la charge ou à a décharge pour maintenir cette puissance électrique en dessous de ladite valeur limite.

4. Procédé selon l'une des revendications 1 à 3, **caractérisé en ce que** la puissance thermique est estimée à chaque instant en tenant compte également de l'état de la santé (SoH) de la batterie.

5. Procédé selon l'une des revendications 1 à 4, **caractérisé en ce qu'**il comporte des étapes préalables d'établissement dudit modèle thermique (MOD_TH) de la batterie.

6. Procédé selon l'une des revendications 1 à 5, **caractérisé en ce qu'**il comporte une étape de vérification du modèle thermique (MOD_TH) de la batterie, par comparaison de la puissance thermique mesurée à plusieurs instants à la charge ou à la décharge avec la puissance thermique estimée auxdits instants à partir du modèle thermique de la batterie, non corrigé de la constante de temps de la batterie.

7. Dispositif (1) de gestion du comportement thermique d'une batterie (BATT), **caractérisé en ce qu'**il comporte :

- Un module de détermination d'une constante de temps ($\tau$) de la batterie, ladite constante de temps correspondant à l'intervalle de temps existant entre le moment où de l'énergie thermique est dégagée par la batterie et le moment où un flux de chaleur correspondant est mesuré en surface de la batterie,
- Un module d'exécution d'un modèle thermique (MOD_TH) de la batterie configuré pour estimer, à chaque instant, une puissance thermique ($W_{th}$) générée par la batterie en fonction d'une puissance électrique ($W_{elect}$) mesurée traversant la batterie, ledit modèle thermique comportant une loi à la charge et une loi à la décharge, chaque loi étant basé sur l'état de charge de la batterie (SoC) et sur sa température (T) et intégrant la constante de temps ($\tau$) de la batterie,
- Un module de contrôle (CTRL) de la puissance thermique générée par la batterie.

8. Dispositif selon la revendication 7, **caractérisé en ce qu'**il comporte :

- Un module d'estimation de la puissance thermique ($W_{th}$) générée à chaque instant par la batterie en fonction de la puissance électrique ($W_{elect}$) fournie à chaque instant par la batterie (BATT) lors de sa charge ou générée à chaque instant par la batterie lors de sa décharge, ladite puissance thermique ($W_{th}$) étant déterminée à partir dudit modèle thermique (MOD_TH),

- Un module de comparaison de la puissance thermique ($W_{th}$) estimée à chaque instant ou d'une variation de la puissance thermique estimée au cours du temps à la charge ou à la décharge avec une valeur limite,
- Un module de contrôle de la puissance électrique ($W_{elect}$) fournie à la batterie lors de la charge ou générée par la batterie lors de la décharge pour maintenir ladite puissance thermique estimée en dessous de ladite valeur limite.

9. Dispositif selon la revendication 7, **caractérisé en ce qu'**il comporte :

- Un module de détermination à chaque instant d'une valeur limite ($W_{elect\_max\_d}$, $W_{elect\_max\_c}$) de puissance électrique admissible par la batterie (BATT) à partir d'une valeur limite de puissance thermique ($W_{th\_max}$) admissible pré-mémorisée injectée dans ledit modèle thermique (MOD_TH),
- Un module de contrôle de la puissance électrique ($W_{elect}$) traversant la batterie (BATT) à la charge ou à la décharge, ledit module étant configuré pour maintenir cette puissance électrique en dessous de ladite valeur limite.

10. Dispositif selon l'une des revendications 8 à 10, **caractérisé en ce que** la puissance thermique est estimée à chaque instant en tenant compte également de l'état de la santé (SoH) de la batterie.

11. Dispositif selon l'une des revendications 7 à 10, **caractérisé en ce qu'**il comporte un module d'établissement dudit modèle thermique (MOD_TH) de la batterie.

12. Dispositif selon l'une des revendications 7 à 11, **caractérisé en ce qu'**il comporte un module de vérification du modèle thermique (MOD_TH) de la batterie, configuré pour comparer la puissance thermique mesurée à plusieurs instants à la charge ou à la décharge avec la puissance thermique estimée auxdits instants à partir du modèle thermique de la batterie, non corrigé de la constante de temps de la batterie.

**Fig. 1**

**Fig. 2**

**Fig. 3**

**Fig. 4**

**Fig. 5**

*Fig. 6*

*Fig. 7*

*Fig. 8*

*Fig. 9*

Europäisches
Patentamt

European
Patent Office

Office européen
des brevets

# RAPPORT DE RECHERCHE EUROPEENNE

**Numéro de la demande**

**EP 21 19 6232**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 108 062 086 A (CHINA AVIATION LITHIUM BATTERY RES INST CO LTD ET AL.) 22 mai 2018 (2018-05-22) | 1,2,4-8, 10-12 | INV. H01M10/0525 H01M10/42 |
| Y | * revendication 1 * ----- | 3,9 | H01M10/44 H01M10/48 |
| Y | US 2019/148952 A1 (REMBOSKI DONALD [US] ET AL) 16 mai 2019 (2019-05-16) * alinéas [0045], [0047], [0050], [0052], [0053]; revendications 1,11; figure 1 * ----- | 3,9 | H01M10/633 H02J7/00 G01R31/367 G01R31/382 G01R31/374 G01R31/392 |
| A | US 2012/188086 A1 (XIE JIAN [US] ET AL) 26 juillet 2012 (2012-07-26) * alinéas [0021], [0024], [0025], [0031]; figures 3, 4B * ----- | 1-12 | |

### DOMAINES TECHNIQUES RECHERCHES (IPC)

H01M
H02J
G01R

Le présent rapport a été établi pour toutes les revendications

| Lieu de la recherche | Date d'achèvement de la recherche | Examinateur |
|---|---|---|
| Munich | 28 janvier 2022 | Letilly, Marika |

## ANNEXE AU RAPPORT DE RECHERCHE EUROPEENNE
## RELATIF A LA DEMANDE DE BREVET EUROPEEN NO.

**EP 21 19 6232**

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

**28-01-2022**

| Document brevet cité au rapport de recherche | Date de publication | Membre(s) de la famille de brevet(s) | Date de publication |
|---|---|---|---|
| CN 108062086    A | 22-05-2018 | AUCUN | |
| US 2019148952   A1 | 16-05-2019 | CN    111758200 A | 09-10-2020 |
| | | DE 112018005834 T5 | 13-08-2020 |
| | | US    2019148952 A1 | 16-05-2019 |
| | | WO    2019099422 A1 | 23-05-2019 |
| US 2012188086   A1 | 26-07-2012 | AUCUN | |

Pour tout renseignement concernant cette annexe : voir Journal Officiel de l'Office européen des brevets, No.12/82

## RÉFÉRENCES CITÉES DANS LA DESCRIPTION

**Documents brevets cités dans la description**

- US 2012188086 A1
- US 2019148952 A1

- CN 108062086 A